# EUROPEAN PATENT APPLICATION

(11) **EP 4 637 176 A1**
(43) Date of publication of application: **22.10.2025**
(21) Application number: 25167102.0
(22) Date of filing: 28.03.2025
(51) Int. Cl.: H04N 25/709, H04N 25/771, H04N 25/79, H04N 25/532

(54) **PHOTOELECTRIC CONVERSION DEVICE AND APPARATUS**

(30) Priority: 15.04.2024 JP 2024065614
(71) Applicant: CANON KABUSHIKI KAISHA, Tokyo 146-8501 (JP)
(72) Inventor: KOBAYASHI, Daisuke, Tokyo, 146-8501 (JP); RYOKI, Tatsuya, Tokyo, 146-8501 (JP)
(74) Representative: TBK

(57) **Abstract**

A photoelectric conversion device (1) including pixels (11) and a processor processing signals read out from the pixels (11), and in which semiconductor substrates (1000, 2000, 3000, 4000) are stacked is provided. Each pixel (11) includes a photoelectric conversion element (PD1, PD2), an amplifier amplifying a signal from the photoelectric conversion element (PD1, PD2) and a capacitor (108, 109, 110) holding an output from the amplifier. The photoelectric conversion device (1) further includes a bias generator (12) supplying, to the amplifier, a bias potential. The semiconductor substrates (1000, 2000, 3000, 4000) include a first substrate (3000) on which the photoelectric conversion element (PD1, PD2) is arranged, a second substrate (4000) on which the capacitor (108, 109, 110) is arranged and a third substrate (2000) on which the processor is arranged, the second substrate (4000) being arranged between the first substrate (3000) and the third substrate (2000). The amplifier includes elements arranged on the first and second substrate (3000, 4000), respectively, and the bias generator (12) is arranged on the third substrate (2000).

## Description

### BACKGROUND OF THE INVENTION

### Field of the Invention

The present invention relates to a photoelectric conversion device and an apparatus.

### Description of the Related Art

In a photoelectric conversion device, it has been proposed to perform a global electronic shutter operation of resetting photoelectric conversion elements arranged in a plurality of pixels and reading out charges from the photoelectric conversion elements simultaneously. Japanese Patent Laid-Open No. 2022-051548 describes an image sensor having a voltage-holding global electronic shutter function of converting a signal charge into a voltage and holding it.

### SUMMARY OF THE INVENTION

To improve the image capturing performance of a photoelectric conversion device, it is considered to stack a plurality of semiconductor substrates and distribute and arrange the components of the photoelectric conversion device on the respective substrates.

Some embodiments of the present disclosure provide a technique advantageous in improving the image capturing performance while implementing a global electronic shutter function.

The present invention in its first aspect provides a photoelectric conversion device as specified in claims 1 to 15.

The present invention in its second aspect provides an apparatus as specified in claim 16.

Further features of the present invention will become apparent from the following description of exemplary embodiments (with reference to the attached drawings).

### BRIEF DESCRIPTION OF THE DRAWINGS

Fig. 1 is a view showing an example of the configuration of a photoelectric conversion device according to an embodiment;
Fig. 2 is a circuit diagram showing an example of the configuration of a pixel and a processing circuit of the photoelectric conversion device shown in Fig. 1;
Fig. 3 is a timing chart for explaining the driving timing of the photoelectric conversion device shown in Fig. 1;
Fig. 4 is a circuit diagram showing an example of the configuration of the pixel and the processing circuit of the photoelectric conversion device shown in Fig. 1;
Fig. 5 is a view showing an example of the configuration of the stacked structure of the photoelectric conversion device shown in Fig. 1;
Fig. 6 is a circuit diagram showing an example of the configuration of the pixel and the processing circuit of the photoelectric conversion device shown in Fig. 1;
Fig. 7 is a view showing an example of the configuration of the stacked structure of the photoelectric conversion device shown in Fig. 1;
Fig. 8 is a circuit diagram showing an example of the configuration of the pixel and the processing circuit of the photoelectric conversion device shown in Fig. 1;
Fig. 9 is a view showing an example of the configuration of the stacked structure of the photoelectric conversion device shown in Fig. 1;
Fig. 10 is a circuit diagram showing an example of the configuration of the pixel and the processing circuit of the photoelectric conversion device shown in Fig. 1;
Fig. 11 is a view showing an example of the configuration of the stacked structure of the photoelectric conversion device shown in Fig. 1;
Fig. 12 is a view showing an example of the configuration of the stacked structure of the photoelectric conversion device shown in Fig. 1;
Fig. 13 is a circuit diagram showing an example of the configuration of the pixel and the processing circuit of the photoelectric conversion device shown in Fig. 1;
Fig. 14 is a view showing an example of the configuration of the stacked structure of the photoelectric conversion device shown in Fig. 1;
Fig. 15 is a view showing an example of the configuration of the stacked structure of the photoelectric conversion device shown in Fig. 1;
Fig. 16 is a circuit diagram showing an example of the configuration of the pixel and the processing circuit of the photoelectric conversion device shown in Fig. 1;
Fig. 17 is a view showing an example of the configuration of the stacked structure of the photoelectric conversion device shown in Fig. 1;
Fig. 18 is a circuit diagram showing an example of the configuration of the pixel and the processing circuit of the photoelectric conversion device shown in Fig. 1;
Fig. 19 is a view showing an example of the configuration of the stacked structure of the photoelectric conversion device shown in Fig. 1;
Fig. 20 is a circuit diagram showing an example of the configuration of the pixel and the processing circuit of the photoelectric conversion device shown in Fig. 1;
Fig. 21 is a view showing an example of the configuration of the stacked structure of the photoelectric conversion device shown in Fig. 1;
Fig. 22 is a circuit diagram showing an example of the configuration of the pixel and the processing circuit of the photoelectric conversion device shown in Fig. 1;
Fig. 23 is a view showing an example of the configuration of the stacked structure of the photoelectric conversion device shown in Fig. 1; and
Fig. 24 is a view showing an example of the configuration of an apparatus incorporating the photoelectric conversion device shown in Fig. 1.

### DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

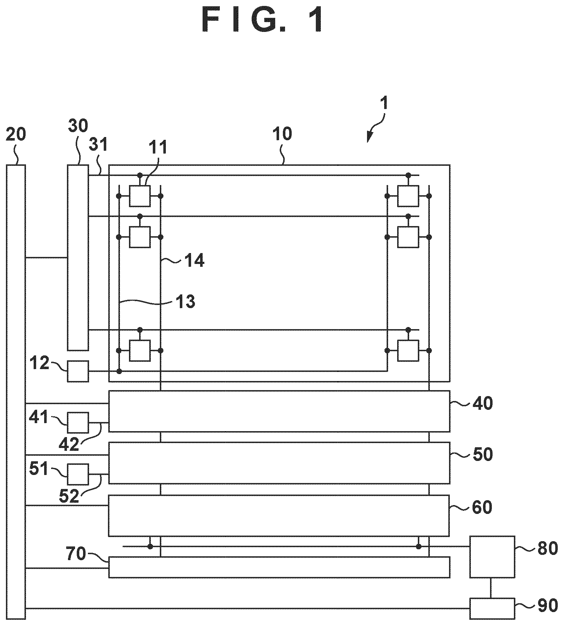

A photoelectric conversion device according to an embodiment of the present disclosure will be described with reference to Figs. 1 to 23. Fig. 1 is a view showing the schematic configuration of a photoelectric conversion device 1 according to this embodiment. The photoelectric conversion device 1 photoelectrically converts a received object image, analog/digital(A/D)-coverts the electrical signal, and outputs the signal as a digital signal. The photoelectric conversion device 1 includes a pixel portion 10, a timing generator 20, a drive controller 30, an amplifier 40, an A/D converter 50, a memory 60, a readout scanner 70, a digital signal processor 80, and an output unit 90. The pixel portion 10 includes a plurality of pixels 11 arranged in a two-dimensional array to form a plurality of rows and a plurality of columns. Bias generators 12, 41, and 51 are connected to the pixel portion 10, the amplifier 40, and the A/D converter 50, respectively, and supply bias potentials for the operations of the pixel portion 10, the amplifier 40, and the A/D converter 50. The amplifier 40 and the A/D converter 50 for processing signals, more specifically, analog signals read out from the plurality of pixels 11 will sometimes be referred to as a processing circuit hereinafter.

The pixel 11 accumulates charges corresponding to incident light by photoelectric conversion, converts the charge signal into a voltage, holds it, and outputs the voltage as a pixel signal. The drive controller 30 controls, via a pixel control line 31, the reset of the pixel 11, transfer of a signal within the pixel 11, and selection of a pixel row in the pixel portion 10 to output signals. The detailed operation of the pixel 11 will be described later. The amplifier 40 is, for example, a current load, and forms, for example, an amplifier such as a source follower circuit together with the amplification transistor provided in the pixel 11. The amplifier 40 amplifies the pixel signal input from the pixel portion 10 via a pixel output line 14, and outputs it to the A/D converter 50. The A/D converter 50 A/D-converts the pixel signal output from the amplifier 40, and outputs it to the memory 60. The memory 60 holds the A/D-converted pixel signal as digital data. The pixel signal held in the memory 60 is transferred to the digital signal processor 80 under the control of the readout scanner 70. The digital signal processor 80 performs, for the transferred pixel signal, digital signal processing such as addition/subtraction between data, addition/subtraction of a digital gain or an offset, decoding, and scramble processing of data. The pixel signal having undergone the digital signal processing is output from the output unit 90. The output unit 90 may have a configuration of outputting a voltage from a single terminal like a buffer circuit or a configuration of a Low Voltage Differential Signaling (LVDS) method with two differential terminals. The output unit 90 may have a parallel/serial conversion function. The timing generator 20 controls the operation timings of the components of the photoelectric conversion device 1.

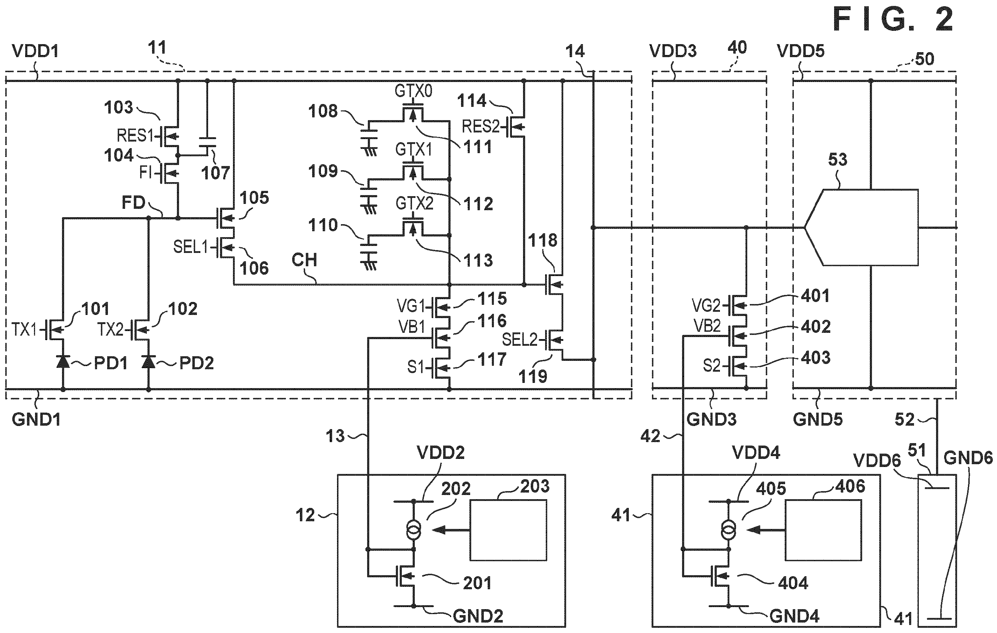

Fig. 2 is an equivalent circuit diagram for explaining the basic configuration of the pixel 11, the processing circuit (the amplifier 40 and the A/D converter 50), and the bias generators 12, 41, and 51 that supply bias potentials to the pixel 11 and the processing circuit. The pixel 11 includes photoelectric conversion elements PD1 and PD2, transfer transistors 101 and 102, a reset transistor 103, a capacitance selection transistor 104, an amplification transistor 105, a selection transistor 106, and a capacitive element 107. In addition, the pixel 11 includes holding capacitors 108 to 110, sample-and-hold (SH) transistors 111 to 113, a reset transistor 114, a cascade transistor 115, a current source transistor 116, and a switch 117. The pixel 11 also includes an amplification transistor 118 and a selection transistor 119. A node connected to the gate electrode of the amplification transistor 105 will sometimes be referred to as a node FD hereinafter, and a node connected to the gate electrode of the amplification transistor 118 will sometimes be referred to as a node CH hereinafter.

The drive controller 30 controls the pixel 11 via the pixel control line 31, as described above. Control signals used by the drive controller 30 to control the pixel 11 are reset pulses RES1 and RES2, transfer pulses TX1 and TX2, selection pulses SEL1 and SEL2, SH pulses GTX0 to GTX2, a bias selection pulse S1, and a capacitance selection signal FI. The reset pulse RES1 controls the operation of the reset transistor 103. The reset pulse RES2 controls the operation of the reset transistor 114. The transfer pulse TX1 controls the operation of the transfer transistor 101. The transfer pulse TX2 controls the operation of the transfer transistor 102. The selection pulse SEL1 controls the operation of the selection transistor 106. The selection pulse SEL2 controls the operation of the selection transistor 119. The SH pulse GTX0 controls the operation of the SH transistor 111. The SH pulse GTX1 controls the operation of the SH transistor 112. The SH pulse GTX2 controls the operation of the SH transistor 113. The bias selection pulse S1 controls the operation of the switch 117. The capacitance selection signal FI controls the operation of the capacitance selection transistor 104.

The cascade transistor 115 and the current source transistor 116 form the source follower (SF) circuit together with the amplification transistor 105, and functions as an amplifier that amplifies the signals from the photoelectric conversion elements PD1 and PD2. In this embodiment, the cascade transistor 115 is arranged as the SF circuit, but the cascade transistor 115 need not be arranged. The bias generator 12 generates a bias potential VG1 and a bias potential VB1, and supplies them to the gate electrodes of the cascade transistor 115 and the current source transistor 116, respectively. It can be said that the bias generator 12 supplies the bias potentials for operating the SF circuit functioning as the amplifier that amplifies the signals from the photoelectric conversion elements PD1 and PD2. The bias potential VB1 is generated by a current generation transistor 201 and a current source 202 that are diode-connected, and supplied to the gate electrode of the current source transistor 116 via a bias line 13. For example, a bias adjuster 203 adjusts the bias potential VB1 by controlling the current value of the current source 202, thereby adjusting the driving force of the SF circuit including the amplification transistor 105 and the current source transistor 116. For example, similar to the bias potential VB1, the bias potential VG1 may be generated using the current source and the current generation transistor in the bias generator 12. Therefore, details of generation of the bias potential VG1 will be omitted.

The amplifier 40 forming the processing circuit includes a cascade transistor 401, a current source transistor 402, and a switch 403. The cascade transistor 401 and the current source transistor 402 form an SF circuit together with the amplification transistor 118 arranged in the pixel 11, and functions as an amplifier that amplifies signals read out from the holding capacitors 108 to 110. In this embodiment, the cascade transistor 401 is arranged as the SF circuit, but the cascade transistor 401 need not be arranged. The bias generator 41 generates bias potentials VG2 and VB2, and supplies them to the gate electrodes of the cascade transistor 401 and the current source transistor 402, respectively. It can be said that the bias generator 41 supplies the bias potentials for operating the SF circuit functioning as the amplifier that amplifies the signals read out from the holding capacitors 108 to 110. The bias potential VB2 is generated by a current generation transistor 404 and a current source 405 that are diode-connected, and supplied to the gate electrode of the current source transistor 402 via a bias line 42. For example, a bias adjuster 406 adjusts the bias potential VB2 by controlling the current value of the current source 405, thereby adjusting the driving force of the SF circuit including the amplification transistor 118 and the current source transistor 402. For example, similar to the bias potential VB2, the bias potential VG2 may be generated using the current source and the current generation transistor in the bias generator 41. Therefore, details of generation of the bias potential VG2 will be omitted.

The A/D converter 50 forming the processing circuit includes an A/D conversion circuit 53. The bias generator 51 generates a bias potential for operating the A/D conversion circuit 53. The bias potential generated by the bias generator 51 is supplied to the A/D converter 50 (A/D conversion circuit 53) via a bias line 52.

In the pixel 11, the bias generator 12, the amplifier 40, the bias generator 41, the A/D converter 50, and the bias generator 51, power supply lines VDD1 to VDD6 and ground lines GND1 to GND6 are arranged as power supply lines. These power supply lines may or may not be connected.

For example, the power supply line VDD1 arranged in the pixel 11 and the power supply line VDD2 arranged in the bias generator 12 may be connected to each other, and similarly, the ground line GND1 arranged in the pixel 11 and the ground line GND2 arranged in the bias generator 12 may be connected to each other. In this case, the bias generator 12 and the SF circuit including the amplification transistor 105 and the current source transistor 116 and functioning as the amplifier that amplifies the signals from the photoelectric conversion elements PD1 and PD2 are supplied with power from a common power supply line. Thus, the operating points and temporal variations of the current source transistor 116 arranged in the pixel 11 and the current generation transistor 201 arranged in the bias generator 12 are common. As a result, the accuracy and stability of the current value of the SF circuit including the amplification transistor 105 and the current source transistor 116 can be improved.

On the other hand, the power supply line VDD1 arranged in the pixel 11 and the power supply line VDD5 arranged in the A/D converter 50 may be separated from each other, and similarly, the ground line GND1 arranged in the pixel 11 and the ground line GND5 arranged in the A/D converter 50 may be separated from each other. In this case, the A/D conversion circuit 53 arranged in the A/D converter 50 and the SF circuit including the amplification transistor 105 and the current source transistor 116 and functioning as the amplifier that amplifies the signals from the photoelectric conversion elements PD1 and PD2 are supplied with power from different power supply lines. This can reduce the influence of crosstalk caused by the operations of the circuits.

As described above, the connection relationships among the power supply lines VDD1 to VDD6 and the ground lines GND1 to GND6 can be decided in consideration of operation timings, power supply voltages to be used, crosstalk, and operating points. Fig. 2 does not illustrate elements connected to the power supply lines VDD3 and VDD6 and the ground line GND6, but elements (not shown) are actually connected. In the accompanying drawings to be described after Fig. 2, the power supply lines VDD1 to VDD6 and the ground lines GND1 to GND6 may be omitted.

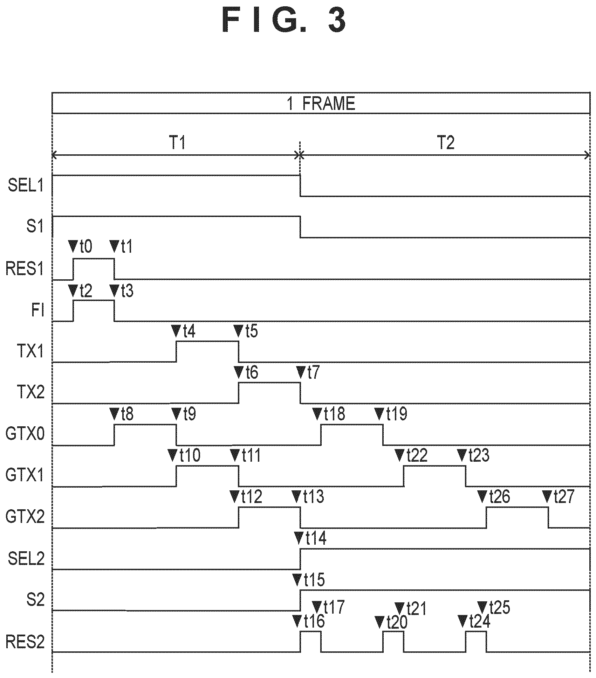

The operation of each circuit during a one-frame period in the photoelectric conversion device 1 will be described next with reference to Fig. 3. A period T1 during which charge signals generated in the photoelectric conversion elements PD1 and PD2 are held as voltage signals in the holding capacitors 108 to 110 and a period T2 during which the voltage signals held in the holding capacitors 108 to 110 are read out to the amplifier 40 and A/D-converted by the A/D converter 50 will be described with reference to Fig. 3. In Fig. 3, assume that each transistor performs an ON operation (each transistor is set in a conductive state) in a case where the control signal supplied from the drive controller 30 is at high level, and each transistor performs an OFF operation (each transistor is set in a non-conductive state) in a case where the control signal is at low level. The relationship between each control signal and the transistor operating in accordance with the control signal is as described above. The charge signals generated in the photoelectric conversion elements PD1 and PD2 and the voltage signals held in the holding capacitors may sometimes collectively be referred to as pixel signals hereinafter.

During the period T1, the selection transistor 106 and the switch 117 perform the ON operations, and outputs from the photoelectric conversion elements PD1 and PD2 can be supplied to the node CH via the SF circuit including the amplification transistor 105 and the current source transistor 116 and functioning as the amplifier. First, the reset transistor 103 performs the ON operation during a period from time t0 to time t1, and the capacitance selection transistor 104 performs the ON operation during a period from time t2 to time t3. Thus, the node FD is reset to a potential level based on the power supply line VDD1. At the same time, the capacitive element 107 is also reset. This period is set as the first reset period. In this case, time t0 and time t2 may be the same timing. Similarly, time t1 and time t3 may be the same timing.

After completion of the first reset period, during a period from time t4 to time t5, the transfer transistor 101 performs the ON operation, and the charge signal of the photoelectric conversion element PD1 is supplied to the node CH via the SF circuit including the amplification transistor 105 and the current source transistor 116. This period is set as the first transfer period. Similarly, during a period from time t6 to time t7, the transfer transistor 102 performs the ON operation, and the charge signal of the photoelectric conversion element PD2 is supplied to the node CH via the SF circuit including the amplification transistor 105 and the current source transistor 116. This period is set as the second transfer period.

In the example shown in Fig. 3, the capacitance selection transistor 104 is driven to perform the OFF operation at time t3. However, the present invention is not limited to this, and the capacitance selection transistor 104 may perform the ON operation during each of the first reset period, the first transfer period, and the second transfer period, thereby making it possible to adjust the potential of the node FD. For example, since the charge signal of the photoelectric conversion element PD1 is converted into a voltage by the capacitance of the node FD during the first transfer period, it is possible to decide a potential in accordance with a capacitance value by causing the capacitance selection transistor 104 to perform the ON operation. The operation of the capacitance selection transistor 104 can appropriately be selected with respect to the charge amounts accumulated in the photoelectric conversion elements PD1 and PD2 in accordance with the dynamic range from the SF circuit including the amplification transistor 105 and the current source transistor 116.

Next, control of the SH transistors 111 to 113 and the voltage signals held in the holding capacitors 108 to 110 will be described. After the end of the first reset period, during a period from time t8 to time t9, the node CH is supplied with the potential (to be sometimes referred to as an N level hereinafter) of the node FD in the reset state via the SF circuit including the amplification transistor 105 and the current source transistor 116. During this period, the SH pulse GTX0 is set at high level at time t8 to cause the SH transistor 111 to perform the ON operation, thereby sampling the N level in the holding capacitor 108 and holding it at time t9. A period from time t10 to time t11 is the first transfer period, and the node CH is supplied with the potential (to be sometimes referred to as an S1 level hereinafter) of the node FD based on the charge signal of the photoelectric conversion element PD1 via the SF circuit including the amplification transistor 105 and the current source transistor 116. During this period, the SH pulse GTX1 is set at high level at time t10 to cause the SH transistor 112 to perform the ON operation, thereby sampling the S1 level in the holding capacitor 109 and holding it at time t11. Similarly, a period from time t12 to time t13 is the second transfer period, and the node CH is supplied with the potential (to be sometimes referred to as an S2 level hereinafter) of the node FD based on the charge signal of the photoelectric conversion element PD2 via the SF circuit including the amplification transistor 105 and the current source transistor 116. During this period, the SH pulse GTX2 is set at high level at time t12 to cause the SH transistor 113 to perform the ON operation, thereby sampling the S2 level in the holding capacitor 110 and holding it at time t12. With these operations, the N level, the S1 level, and the S2 level are held as voltage signals in the holding capacitors 108 to 110. In this case, a period during which the voltage signals are sampled and held in the holding capacitors 108 to 110 is set as a voltage holding operation period.

The series of operations from the first reset period to the voltage holding operation period is a pixel signal voltage holding operation. By simultaneously performing the pixel signal voltage holding operation for all the pixels, the global electronic shutter operation can be implemented. Among the plurality of pixels 11 arranged in the pixel portion 10, the pixel signal voltage holding operation may be performed for all the pixels 11 or some of the pixels 11. For example, the pixel signal voltage holding operation may sequentially be performed for a unit of a plurality of pixel rows or for a unit of a plurality of pixel columns. Alternatively, the pixel signal voltage holding operation may be performed for each row.

After the pixel signal voltage holding operation, the voltage signals held in the holding capacitors 108 to 110 are read out to the amplifier 40 and the A/D converter 50. During the period T2 shown in Fig. 3, the selection transistor 106 and the switch 117 perform the OFF operations. This sets the amplification transistor 105 and the cascade transistor 115 in a non-connection state. Furthermore, when the switch 117 performs the OFF operation, the current supplied by the current source transistor 116 is interrupted, and the SF circuit including the amplification transistor 105 and the current source transistor 116 is set in a non-operating state. Thus, the node CH becomes floating. On the other hand, the selection transistor 119 is caused to perform the ON operation at time t14 and the switch 403 is caused to perform the ON operation at time t15. This sets a state in which the node CH is connected to the A/D conversion circuit 53 via the SF circuit including the amplification transistor 118 and the current source transistor 402 and functioning as the amplifier that amplifies the signals read out from the holding capacitors 108 to 110. In this example, time t14 and time t15 may be the same timing.

During a period from time t16 to time t17, the reset transistor 114 performs the ON operation and the node CH is reset to the potential level based on the power supply line VDD1. This period is set as the second reset period.

After the second reset period, during a period from time t18 to time t19, the SH pulse GTX0 is set at high level to cause the SH transistor 111 to perform the ON operation, thereby outputting the voltage signal held in the holding capacitor 108 to the node CH. The A/D conversion circuit 53 A/D-converts the voltage signal held in the holding capacitor 108, which has been read out via the SF circuit including the amplification transistor 118 and the current source transistor 402, that is, the voltage based on the N level. This period is set as the first A/D conversion period. The potential of the node CH is decided in accordance with the capacitance of the node CH, for example, the wiring pattern, the diffusion capacitances of the SH transistors 111 to 113, the ratio between the capacitance value of the gate electrode of the amplification transistor 118 or the like and the capacitance value of each of the holding capacitors 108 to 110, and the potential difference of each node. Therefore, in the operation shown in Fig. 3, the second reset period is provided to reset the node CH to a predetermined potential before reading out the voltage held in each of the holding capacitors 108 to 110.

After the second reset period from time t20 to time t21, during a period from time t22 to time t23, the SH pulse GTX1 is set at high level to cause the SH transistor 112 to perform the ON operation, thereby outputting the voltage signal held in the holding capacitor 109 to the node CH. The A/D conversion circuit 53 A/D-converts the voltage signal held in the holding capacitor 109, which has been read out via the SF circuit including the amplification transistor 118 and the current source transistor 402, that is, the voltage based on the S1 level. This period is set as the second A/D conversion period.

Furthermore, after the second reset period from time t24 to time t25, during a period from time t26 to time t27, the SH pulse GTX2 is set at high level to cause the SH transistor 113 to perform the ON operation, thereby outputting the voltage signal held in the holding capacitor 110 to the node CH. The A/D conversion circuit 53 A/D-converts the voltage signal held in the holding capacitor 110, which has been read out via the SF circuit including the amplification transistor 118 and the current source transistor 402, that is, the voltage based on the S2 level. This period is set as the third A/D conversion period.

The period T2 ends after the third A/D conversion period, and the selection transistor 119 and the switch 403 perform the OFF operations. This sets the amplification transistor 118 and the cascade transistor 401 in a non-connection state. Furthermore, when the switch 403 performs the OFF operation, the current supplied by the current source transistor 402 is interrupted, and the SF circuit including the amplification transistor 118 and the current source transistor 402 is set in a non-operating state.

In the operation shown in Fig. 3, the reset operations of the photoelectric conversion elements PD1 and PD2 are not apparently indicated. However, for example, the time after each of the first transfer period and the second transfer period may be set as the accumulation start time. During the period T2 or timings (not shown) other than the periods T1 and T2, the transfer transistor 101, the transfer transistor 102, the reset transistor 103, and the capacitance selection transistor 104 perform the ON operations in accordance with the control signals. This may reset the photoelectric conversion elements PD1 and PD2 to the potential based on the power supply line VDD1.

In the configuration of the pixel 11 shown in Fig. 2, the two photoelectric conversion elements PD1 and PD2 are arranged. In this case, phase difference detection and generation of a stereoscopic image may be performed based on output difference information of the photoelectric conversion elements PD1 and PD2. Alternatively, a sensitivity difference may be given between the photoelectric conversion elements PD1 and PD2, and the outputs of the photoelectric conversion elements PD1 and PD2 may be combined or appropriately used for a bright portion and a dark portion with respect to the same captured image, thereby generating an image having a high dynamic range. The sensitivity difference between the photoelectric conversion elements PD1 and PD2 may be implemented by, for example, changing the transmittance of light by color filters, microlenses, metal layers, and the like arranged on the light incident side of the photoelectric conversion elements PD1 and PD2. Alternatively, for example, the sensitivity difference between the photoelectric conversion elements PD1 and PD2 may be implemented by changing the sizes of the photoelectric conversion elements PD1 and PD2. In addition, only one photoelectric conversion element may be arranged in the pixel 11.

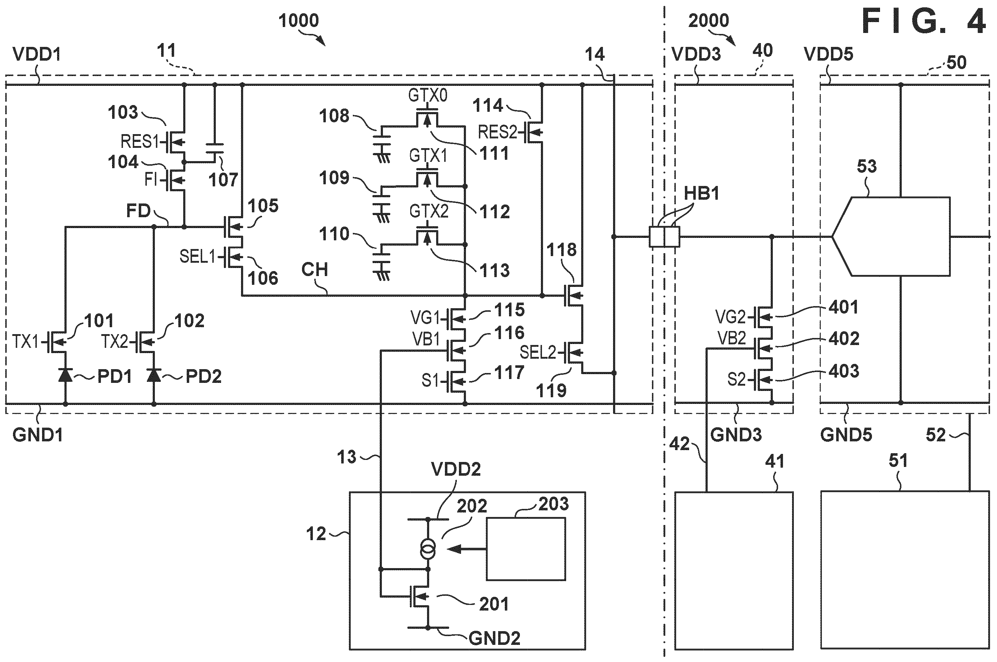

Fig. 4 is an equivalent circuit diagram for explaining a configuration example in which the pixels 11, the processing circuit (the amplifier 40 and the A/D converter 50), and the bias generators 12, 41, and 51 are distributed and arranged on a plurality of semiconductor substrates according to this embodiment. The pixels 11, the amplifier 40, the A/D converter 50, and the bias generators 12, 41, and 51, which have been described with reference to Fig. 2, may be arranged on one semiconductor substrate. Furthermore, the drive controller 30, the memory 60, the readout scanner 70, the digital signal processor 80, and the output unit 90, which have been described with reference to Fig. 1, may also be arranged on the same semiconductor substrate. In a case where the pixels 11, the processing circuit (the amplifier 40 and the A/D converter 50), and the bias generators 12, 41, and 51 are arranged on one semiconductor substrate, the length of the pixel output line 14 that connects the pixels 11 and the processing circuit (the amplifier 40 and the A/D converter 50) becomes longer in proportion to the size of the pixel portion 10. Therefore, the readout time increases due to the parasitic capacitance load of the long pixel output line 14, and for example, the chip area increases.

To cope with this, as shown in Fig. 4, the pixel portion 10 and the bias generator 12 that supplies the bias potential for operating the SF circuit including the amplification transistor 105 and the current source transistor 116 of the pixel 11 and functioning as the amplifier are arranged on a semiconductor substrate 1000. In addition, the processing circuit (the amplifier 40 and the A/D converter 50) and the bias generators 41 and 51 that supply the bias potentials for operating the processing circuit are arranged on a semiconductor substrate 2000 different from the semiconductor substrate 1000. The semiconductor substrates 1000 and 2000 are stacked, and the pixel output line 14 is electrically connected between the semiconductor substrates 1000 and 2000 via connecting portions HB1 using, for example, hybrid bonding. The connecting portions HB1 are not limited to hybrid bonding, and the semiconductor substrates 1000 and 2000 may be connected using conductive vias, bumps, or the like.

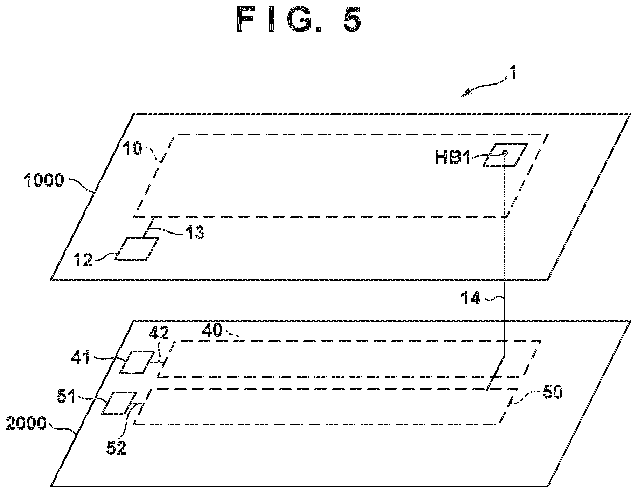

Fig. 5 is a view obtained when stereoscopically viewing the configuration shown in Fig. 4. As shown in Fig. 5, the photoelectric conversion device 1 has a configuration in which a plurality of semiconductor substrates including the semiconductor substrates 1000 and 2000 are stacked. Fig. 5 shows a configuration in which the amplifier 40 and the A/D converter 50 arranged on the semiconductor substrate 2000 are located immediately below the pixel portion 10 arranged on the semiconductor substrate 1000. With the configuration shown in Fig. 5, the pixel output line 14 can be shortened, as compared to the configuration in which the pixel portion 10 and the processing circuit (the amplifier 40 and the A/D converter 50) are arranged on one semiconductor substrate. This can reduce the parasitic capacitance of the pixel output line 14, thereby shortening the readout time during which the signals are read out from the pixel portion 10 (pixels 11). In addition, an increase in chip area can be suppressed. That is, it is possible to improve the image capturing performance of the photoelectric conversion device 1.

The above-described drive controller 30, memory 60, readout scanner 70, digital signal processor 80, and output unit 90 may also be arranged on the semiconductor substrate 2000. Alternatively, some or all of the drive controller 30, the memory 60, the readout scanner 70, the digital signal processor 80, and the output unit 90 may be arranged on a semiconductor substrate different from the semiconductor substrates 1000 and 2000. This can further suppress an increase in chip area.

In the configuration shown in Figs. 4 and 5, the pixel portion 10 (pixels 11) and the bias generator 12 for operating the amplifiers arranged in the pixels 11 are arranged on the same semiconductor substrate 1000. The processing circuit (the amplifier 40 and the A/D converter 50) and the bias generators 41 and 51 for operating the processing circuit are arranged on the same semiconductor substrate 2000. As described above with reference to Fig. 2, the gate electrode of the current source transistor 116 of the pixel 11 is supplied with the bias potential VB1 from the current generation transistor 201 of the bias generator 12. The current generation transistor 201 forms a so-called current mirror with the current source transistor 116, and the accuracy of the current is decided in accordance with the pairing property between the current source transistor 116 and the current generation transistor 201. When the current source transistor 116 and the current generation transistor 201 are arranged on the same semiconductor substrate 1000, this improves the pairing property. At the time of the global electronic shutter operation, the SF circuit including the amplification transistor 105 and the current source transistor 116 can operate in all the pixels 11, and thus the power consumption of the semiconductor substrate 1000 increases. Therefore, the accuracy of the generated current of the current source transistor 116 that decides the driving current of the SF circuit including the amplification transistor 105 and the current source transistor 116 is important to improve accuracy when designing power consumption. By arranging the pixel portion 10 and the bias generator 12 on the same semiconductor substrate 1000, as in the configuration shown in Figs. 4 and 5, it is possible to improve the accuracy of the generated current of the current source transistor 116 as a current source forming the SF circuit together with the amplification transistor 105. Similarly, the amplifier 40, the A/D converter 50, and the bias generators 41 and 51 are arranged on the semiconductor substrate 2000. This can improve accuracy when designing power consumption. As a result, the image capturing performance of the photoelectric conversion device 1 can be improved.

In the configuration shown in Figs. 4 and 5, one bias generator 12 is arranged for the pixel portion 10. However, the present invention is not limited to this, and a plurality of bias generators 12 may be arranged for the pixel portion 10. Thus, even if a transient variation occurs in the bias line 13 due to a kickback via the parasitic capacitance when driving all the pixels 11, it is possible to improve responsiveness. In addition, if crosstalk between the pixels 11 via the common bias line 13 occurs in all the pixels 11, the crosstalk between the pixels 11 can be reduced by arranging the plurality of bias generators 12 and separating the bias line 13 for each bias generator 12. With this configuration, it is possible to improve the image capturing performance of the photoelectric conversion device 1 and image quality.

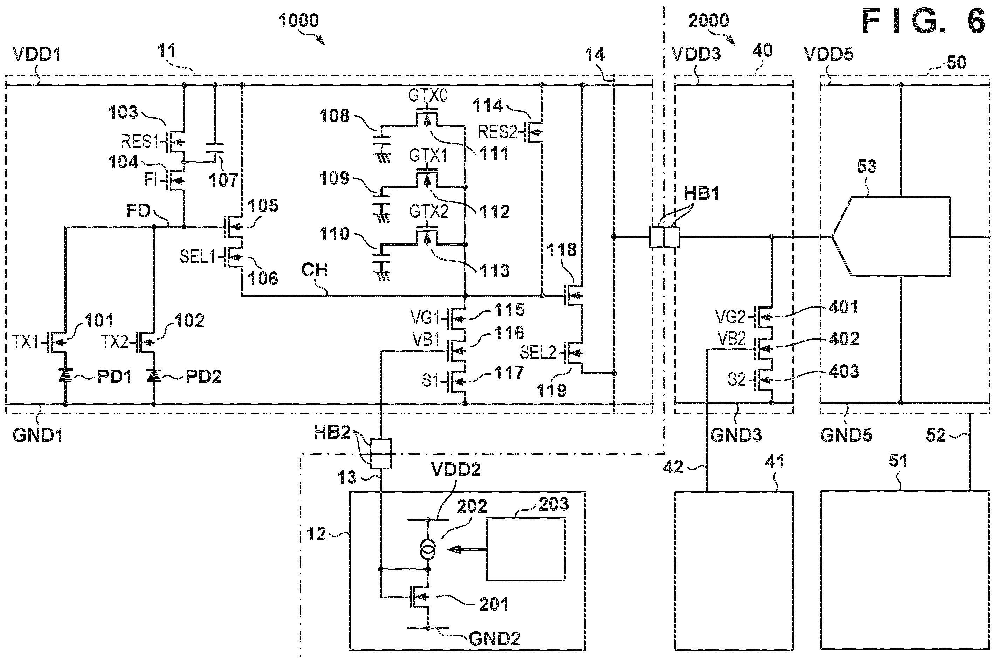

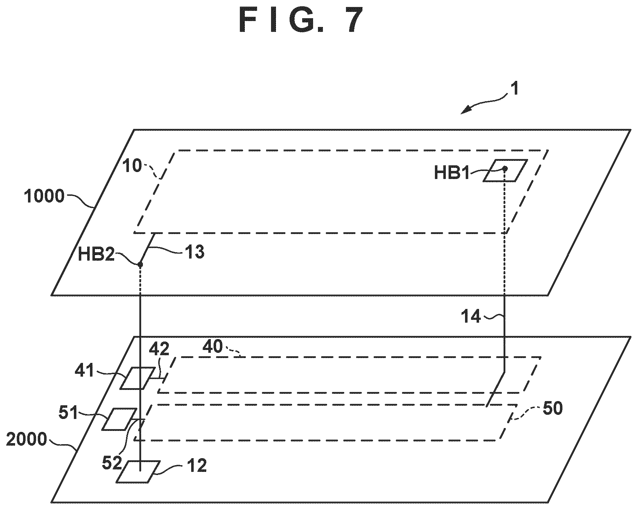

Fig. 6 is an equivalent circuit diagram for explaining a configuration example in which the pixels 11, the processing circuit (the amplifier 40 and the A/D converter 50), and the bias generators 12, 41, and 51 are distributed and arranged on a plurality of semiconductor substrates according to this embodiment, and shows a modification of the configuration shown in Fig. 4. In the configuration shown in Fig. 6, the bias generator 12 is arranged on the semiconductor substrate 2000. The bias line 13 that connects the bias generator 12 and the gate electrode of the current source transistor 116 is electrically connected between the semiconductor substrates 1000 and 2000 via connecting portions HB2. Fig. 7 is a view obtained when stereoscopically viewing the configuration shown in Fig. 6.

The size of the photoelectric conversion device 1 may be decided based on the size of the semiconductor substrate 1000, in other words, the size of the region of the pixel portion 10, that is, the size of the pixel 11 and the number of arranged pixels 11. In the configuration shown in Figs. 4 and 5, the bias generator 12 needs to be arranged in a region of the semiconductor substrate 1000, different from a region where the pixel portion 10 is arranged. Therefore, by arranging the bias generator 12 on the semiconductor substrate 1000, the chip area of the semiconductor substrate 1000, more specifically, the chip area of the photoelectric conversion device 1 may increase. To cope with this, by arranging the bias generator 12 on the semiconductor substrate 2000, the size of the semiconductor substrate 1000 is roughly decided based on the size of the pixel portion 10. Although depending on the size of the pixel 11 and the number of pixels 11 necessary for the photoelectric conversion device 1, it may be possible to suppress an increase in chip area of the photoelectric conversion device 1 by arranging the bias generator 12 on the semiconductor substrate 2000.

Furthermore, depending on the types of the elements forming the pixel 11 and the types of the elements forming the bias generator 12, it may be suitable to arrange the bias generator 12 on the semiconductor substrate 2000. For example, if an elements that operate at a plurality of power source voltages, passive elements, active elements, and the like are formed on the same semiconductor substrate, a semiconductor manufacturing process may become complicated, thereby influencing cost and restriction of performance. On the semiconductor substrate 2000, a plurality of functional blocks including the amplifier 40 and the A/D converter 50 are arranged. Therefore, it is necessary to form elements that operate at a plurality of power source voltages, passive elements, active elements, and the like on the semiconductor substrate 2000. To cope with this, the bias generator 12 or a part of the bias generator 12 is arranged on the semiconductor substrate 2000. Thus, it may be possible to optimize the process when manufacturing the semiconductor substrates 1000 and 2000. To optimize the semiconductor manufacturing process, for example, a process specialized in improving the performance of each of the photoelectric conversion elements PD1 and PD2 may be applied in manufacturing the semiconductor substrate 1000. This can improve the image capturing performance of the photoelectric conversion device 1.

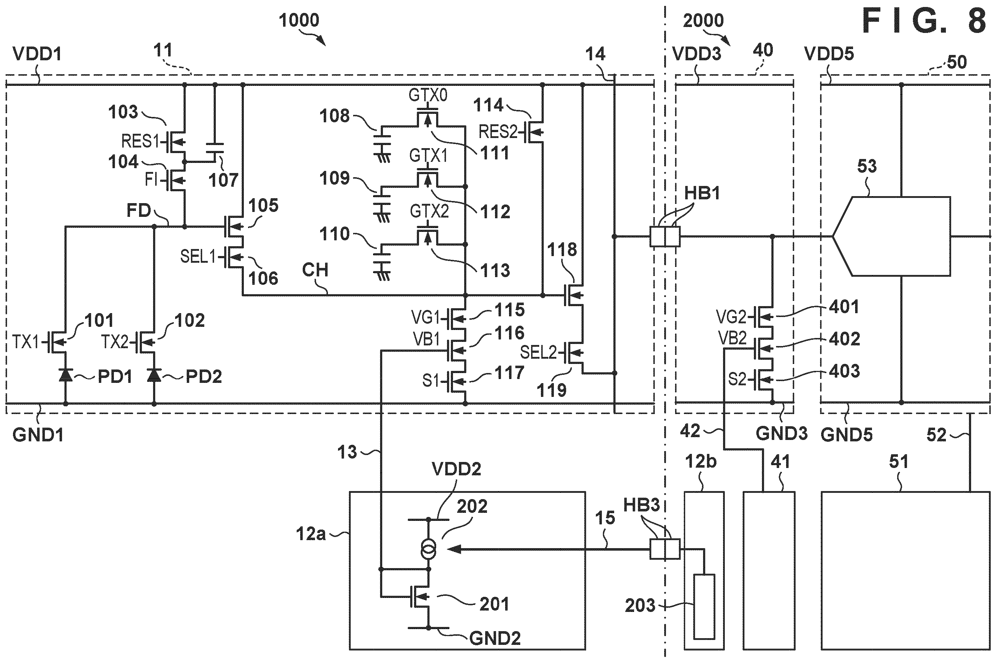

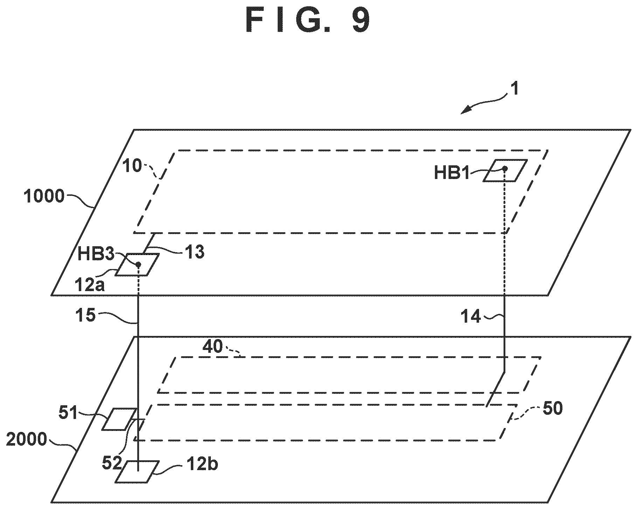

Fig. 8 is an equivalent circuit diagram for explaining a configuration example in which the pixels 11, the processing circuit (the amplifier 40 and the A/D converter 50), and the bias generators 12, 41, and 51 are distributed and arranged on a plurality of semiconductor substrates according to this embodiment, and shows a modification of the configuration shown in each of Figs. 4 and 6. Fig. 9 is a view obtained when stereoscopically viewing the configuration shown in Fig. 8.

As shown in Fig. 8, the bias generator 12 includes an element arranged on the semiconductor substrate 1000 and an element arranged on the semiconductor substrate 2000. In a bias generator 12a, arranged on the semiconductor substrate 1000, of the bias generator 12, the current generation transistor 201 and the current source 202 are arranged. In a bias generator 12b, arranged on the semiconductor substrate 2000, of the bias generator 12, the bias adjuster 203 is arranged. The bias generators 12a and 12b are electrically connected by a bias adjustment control line 15 via connecting portions HB3. In this configuration, it is possible to keep the pairing property of the current mirror configuration of the current source transistor 116 and the current generation transistor 201. By arranging the bias generator 12b on the semiconductor substrate 2000, it is possible to suppress the number of elements arranged on the semiconductor substrate 1000, as compared to the configuration shown in Figs. 4 and 5. On the other hand, the bias adjuster 203 is arranged on the semiconductor substrate 2000. This can form the bias adjuster 203 using a logic circuit and elements that operate at a plurality of power supply voltages.

Furthermore, for example, if the current source 202 is formed by a passive element such as a resistance, the current source 202 may be arranged on the semiconductor substrate 2000. Form the viewpoint of suppressing noise of the SF circuit including the amplification transistor 105 and the current source transistor 116, it is considered to increase the gate area of the current generation transistor 201. From the same viewpoint, it is considered to adjust the LW ratio of the gate electrode to increase the mirror ratio with respect to the current source transistor 116 of the current generation transistor 201. For example, if the area of the gate electrode of the current generation transistor 201 is increased by A times while keeping the LW ratio of the gate electrode, it is possible to reduce random noise generated in the current generation transistor 201 to about 1/√A. Thus, for example, only the current generation transistor 201 is arranged in the bias generator 12a arranged on the semiconductor substrate 1000. Therefore, it is possible to increase the area of the gate electrode of the current generation transistor 201, as compared to the configuration in which the current source 202, the bias adjuster 203, and the like are arranged on the semiconductor substrate 1000 as shown in Fig. 4. Furthermore, with respect to the LW ratio of the gate electrode of the current generation transistor 201, the degree of freedom of design increases, and noise of the SF circuit including the amplification transistor 105 and the current source transistor 116 is reduced, resulting in a reduction of noise of the pixel signal. With respect to the plurality of elements forming the bias generator 12, a combination of the elements arranged on the semiconductor substrate 1000 and a combination of the elements arranged on the semiconductor substrate 2000 are not limited to the above combinations, and are designed appropriately.

As described above, the bias generator 12 that drives the current source transistor 116 of the pixel 11 is arranged on the same semiconductor substrate or different semiconductor substrates in consideration of the types of the elements, the power supply voltage, the current accuracy, the noise performance, the area, and the like. Thus, it is possible to, for example, improve performance by optimizing the semiconductor manufacturing process and reduce noise of the pixel signal by improving the degree of freedom of design, thereby improving the image capturing performance of the photoelectric conversion device 1.

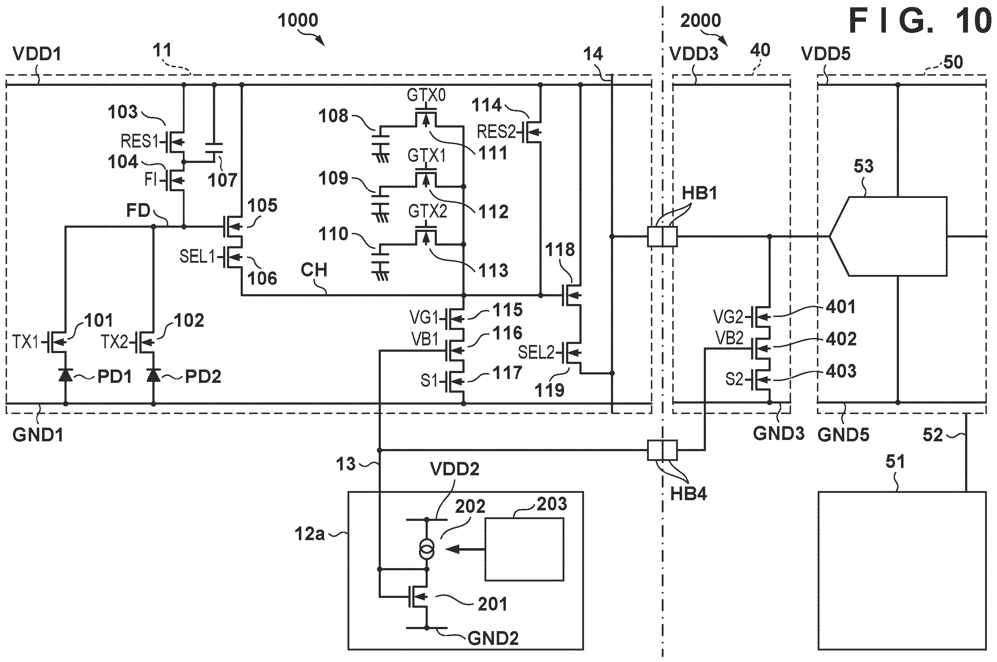

Fig. 10 is an equivalent circuit diagram for explaining a configuration example in which the pixels 11, the processing circuit (the amplifier 40 and the A/D converter 50), and the bias generators 12 and 51 are distributed and arranged on a plurality of semiconductor substrates according to this embodiment. As compared to the above-described embodiment, a component for supplying a bias potential for operating the amplifier 40 is different. Components different from the above-described embodiment will mainly be described below and a description of components that may be the same as in the above-described embodiment will be omitted appropriately.

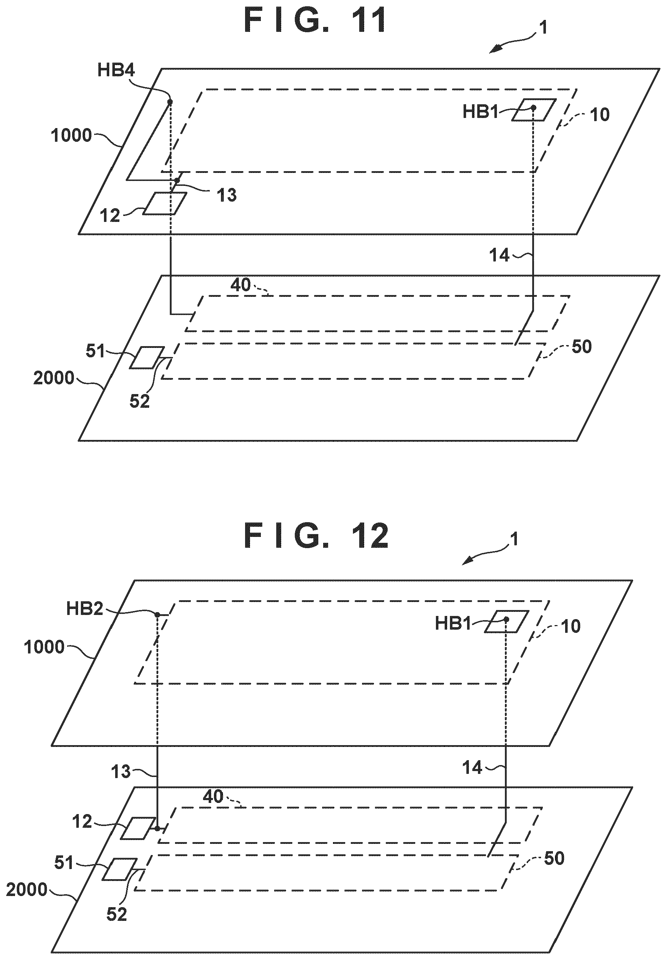

In the configuration shown in Fig. 10, the bias generator 12 is arranged on the semiconductor substrate 1000. The bias potential generated by the bias generator 12 is supplied, via the bias line 13, to the current source transistor 116 arranged in the pixel 11, similar to the above-described embodiment. Furthermore, as shown in Fig. 10, the bias line 13 connected to the bias generator 12 is connected, via connecting portions HB4, to the current source transistor 402 of the amplifier 40 arranged on the semiconductor substrate 2000. Thus, the bias generator 12 supplies the bias potential not only to the current source transistor 116 but also to the current source transistor 402. Fig. 11 is a view obtained when stereoscopically viewing the configuration shown in Fig. 10.

As described above with reference to Fig. 3, the driving timings in the one-frame period are divided into the period T1 during which the charge signals generated in the photoelectric conversion elements PD1 and PD2 are held as the voltage signals and the period T2 during which the held voltage signals are read out. The SF circuit including the amplification transistor 105 and the current source transistor 116 arranged in the pixel 11 is driven during the period T1. The SF circuit formed by including the amplification transistor 118 arranged in the pixel 11 and the current source transistor 402 arranged in the amplifier 40 is driven during the period T2. In the above-described embodiment, the bias generator 12 that operates the SF circuit including the amplification transistor 105 and the current source transistor 116 and the bias generator 41 that operates the SF circuit including the amplification transistor 118 and the current source transistor 402 are separately arranged. The reason for this is, for example, that the SF circuits are individually driven, that different driving forces are used in the SF circuits, or that mutual crosstalk caused by the operations of the SF circuits is suppressed. However, the driving timings of the SF circuits are different between the periods T1 and T2. To cope with this, during each of the periods T1 and T2, by controlling the driving force using the bias adjuster 203, one bias generator 12 can be shared by the SF circuit including the amplification transistor 105 and the current source transistor 116 and the SF circuit including the amplification transistor 118 and the current source transistor 402. That is, a plurality of blocks can share the bias generator, thereby reducing the power consumption and the area.

In the configuration shown in Fig. 10, the pixel portion 10 (bias generator 12) and the amplifier 40 (bias generator 41) are shared as one bias generator. However, the present invention is not limited to this, and the pixel portion 10 (bias generator 12) and the A/D converter 50 (bias generator 51) may be shared as one bias generator, or the amplifier 40 (bias generator 41) and the A/D converter 50 (bias generator 51) may be shared as one bias generator. Furthermore, the pixel portion 10, the amplifier 40, and the A/D converter 50 may be shared as one bias generator.

Fig. 12 is a view showing a modification of Fig. 11. Referring to Fig. 12, the bias generator 12 is arranged on the semiconductor substrate 2000. Thus, similar to the configuration shown in Fig. 6, it is possible to suppress the chip area and optimize the semiconductor manufacturing process.

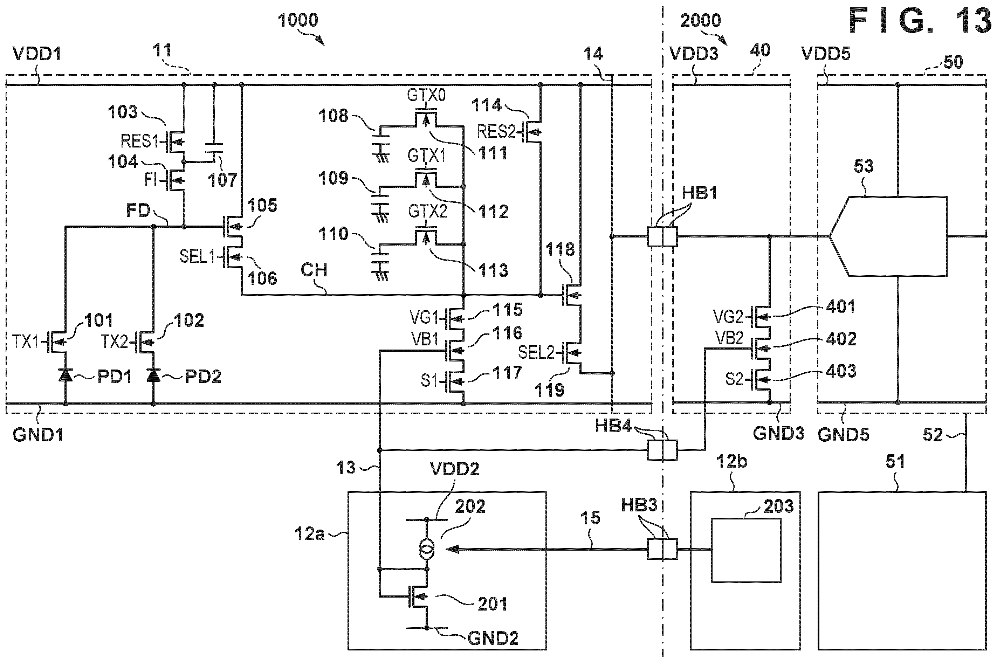

Fig. 13 is an equivalent circuit diagram for explaining a configuration example in which the pixels 11, the processing circuit (the amplifier 40 and the A/D converter 50), and the bias generators 12, 41, and 51 are distributed and arranged on a plurality of semiconductor substrates according to this embodiment. In the configuration shown in Fig. 13, the bias generator 12 includes an element arranged on the semiconductor substrate 1000 and an element arranged on the semiconductor substrate 2000, similar to the configuration described with reference to Fig. 8. In the configuration shown in Fig. 13, the pixel portion 10 (pixels 11) and the amplifier 40 share one bias generator 12, similar to the configuration shown in Fig. 10.

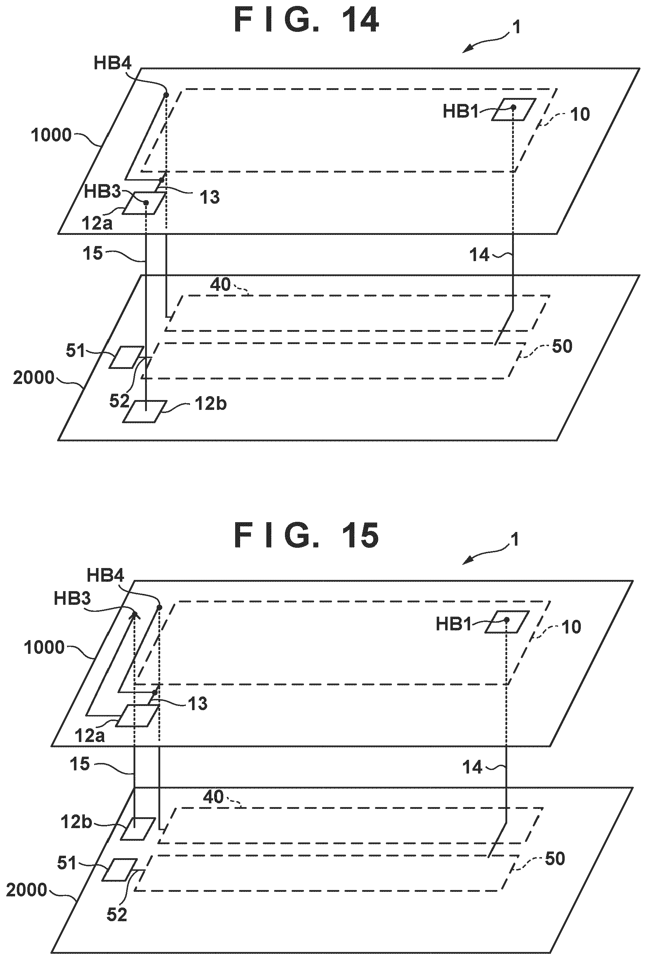

Fig. 14 is a view obtained when stereoscopically viewing the configuration shown in Fig. 13. Fig. 15 is a view showing a modification of Fig. 14. Figs. 14 and 15 are different in terms of the arrangement position of the bias generator 12b. The configuration shown in Fig. 15 shows an example in which the bias generator 12b is arranged at a location where the bias generator 41 is arranged in Fig. 5.

As shown in Figs. 13 to 15, a plurality of blocks share the bias generator 12. The bias generator 12 is distributed and arranged on the semiconductor substrates 1000 and 2000. This can obtain the effects of reducing the power consumption and reducing the area, as described above with reference to Figs. 8 to 12, and improving the degree of freedom of the arrangement plan.

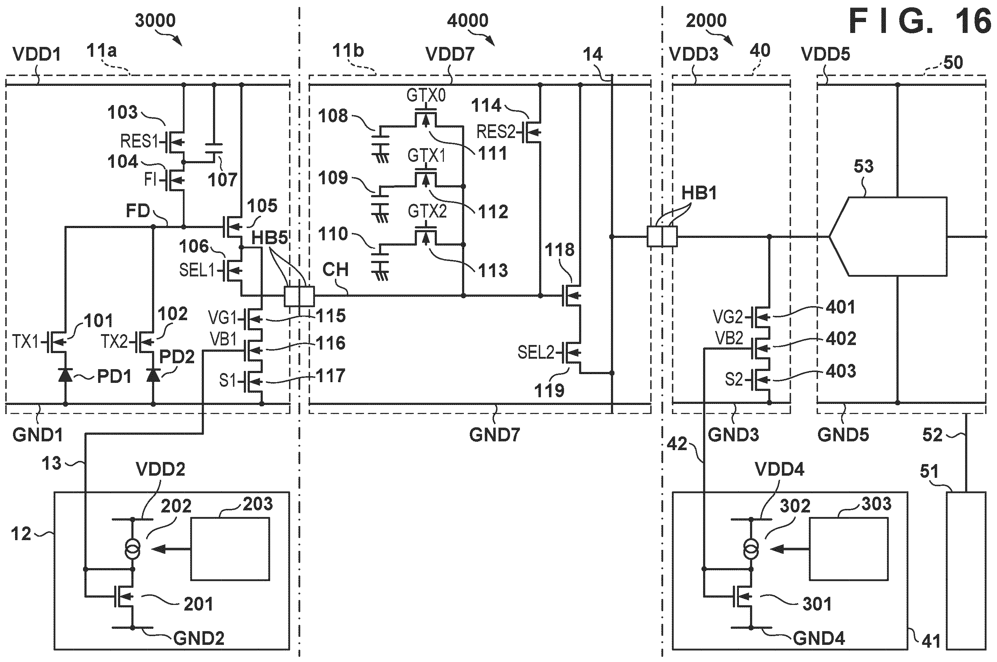

Fig. 16 is an equivalent circuit diagram for explaining a configuration example in which the pixels 11, the processing circuit (the amplifier 40 and the A/D converter 50), and the bias generators 12, 41, and 51 are distributed and arranged on a plurality of semiconductor substrates according to this embodiment. In the configuration shown in Fig. 16, three layers of semiconductor substrates 3000 and 4000 and the semiconductor substrate 2000 are stacked, and the pixels 11, the processing circuit (the amplifier 40 and the A/D converter 50), and the bias generators 12, 41, and 51 are distributed and arranged on the three semiconductor substrates 3000, 4000, and 2000. Components different from the above-described embodiment will mainly be described below and a description of components that may be the same will be omitted appropriately.

In a case where many elements are included in one pixel 11, if the pixel portion 10 (pixel 11) is arranged on one semiconductor substrate 1000 as in the above-described embodiment, the maximum accumulated charge amounts of the photoelectric conversion elements PD1 and PD2 may be limited due to, for example, the restriction of the area. In addition, the size of the transistor such as the amplification transistor 105 and the current source transistor 116 may be restricted. That is, circuit noise design may be restricted. To cope with this, in the configuration shown in Fig. 16, a part of the pixel 11 is arranged on each of the semiconductor substrates 3000 and 4000, and the elements of the pixel 11 arranged on the semiconductor substrates 3000 and 4000 are electrically connected using connecting portions HB5.

A pixel 11a of the pixel 11 is arranged on the semiconductor substrate 3000. The pixel 11a includes the photoelectric conversion elements PD1 and PD2, the transfer transistors 101 and 102, the reset transistor 103, the capacitance selection transistor 104, the amplification transistor 105, the selection transistor 106, and the capacitive element 107. In addition, the pixel 11a includes the cascade transistor 115, the current source transistor 116, and the switch 117. As described above, the amplification transistor 105, the cascade transistor 115, and the current source transistor 116 form the SF circuit functioning as the amplifier that amplifies the signals from the photoelectric conversion elements PD1 and PD2. The cascade transistor 115 need not be arranged. In this embodiment, the whole SF circuit functioning as the amplifier that amplifies the signals from the photoelectric conversion elements PD1 and PD2 is arranged on the semiconductor substrate 3000. Furthermore, in the configuration shown in Fig. 16, the bias generator 12 is arranged on the semiconductor substrate 3000.

A pixel 11b of the pixel 11 is arranged on the semiconductor substrate 4000. The pixel 11b includes the holding capacitors 108 to 110, the SH transistors 111 to 113, the reset transistor 114, the amplification transistor 118, and the selection transistor 119. As described above, the amplification transistor 118, and the cascade transistor 401 and the current source transistor 402 of the amplifier 40 form the SF circuit functioning as the amplifier that amplifies the signals read out from the holding capacitors 108 to 110.

On the semiconductor substrates 3000 and 4000, the node CH and the output node of the SF circuit including the amplification transistor 105 and the current source transistor 116 are electrically connected via the connecting portions HB5. Similar to the above-described embodiment, the processing circuit (the amplifier 40 and the A/D converter 50) is arranged on the semiconductor substrate 2000. The configuration of the semiconductor substrate 2000 may be, for example, the same as that shown in Fig. 4 and a detailed description thereof will be omitted, but the semiconductor substrates 4000 and 2000 are connected via the connecting portions HB1. With this configuration, the pixel output line 14 and the A/D conversion circuit 53 are electrically connected via the connecting portions HB1. Furthermore, in the configuration shown in Fig. 16, the bias generators 41 and 51 are arranged on the semiconductor substrate 2000. In Fig. 16, with respect to the power supply line VDD and the ground line GND of the pixel 11, the power supply line VDD1 and the ground line GND1 are shown for the pixel 11a, and a power supply line VDD7 and a ground line GND7 are shown for the pixel 11b. However, as described above, these lines may or may not be connected. For example, the power supply line VDD1 arranged in the pixel 11a and the power supply line VDD7 arranged in the pixel 11b may be connected to each other, and similarly, the ground line GND1 arranged in the pixel 11a and the ground line GND7 arranged in the pixel 11b may be connected to each other. Furthermore, for example, the power supply line VDD1 arranged in the pixel 11a and the power supply line VDD2 arranged in the bias generator 12 may be connected to each other, and similarly, the ground line GND1 arranged in the pixel 11a and the ground line GND2 arranged in the bias generator 12 may be connected to each other.

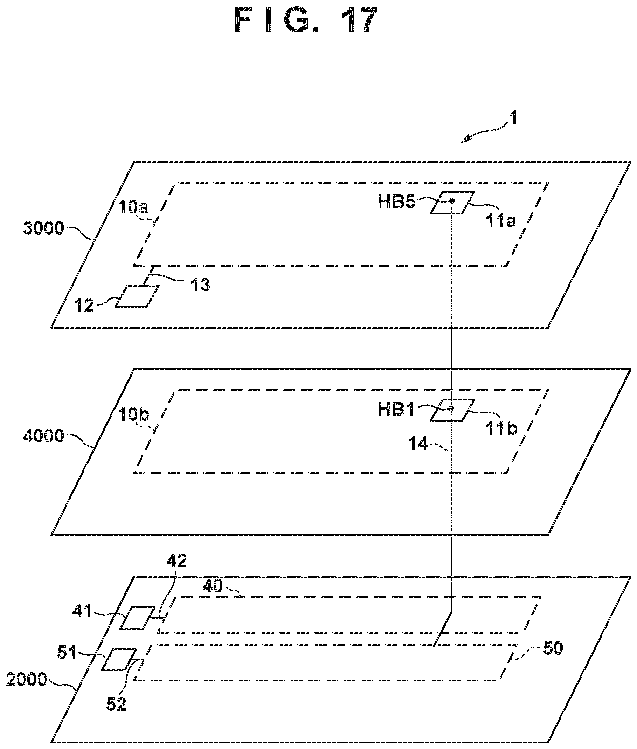

Fig. 17 is a view obtained when stereoscopically viewing the configuration shown in Fig. 16. The pixel portion 10 includes a pixel portion 10a arranged on the semiconductor substrate 3000 and a pixel portion 10b arranged on the semiconductor substrate 4000 in correspondence with the pixels 11a and 11b.

In the configuration shown in Figs. 16 and 17, the current source transistor 116 and the bias generator 12 are arranged on the same semiconductor substrate 3000. This can improve the accuracy of the current value generated by the current source transistor 116. By arranging the pixels 11a and 11b on the different semiconductor substrates 3000 and 4000, it is possible to improve the degree of freedom of design such as the area and arrangement of the elements forming the pixel 11. For example, it is possible to attempt to increase the maximum accumulated charge amounts by increasing the areas of the photoelectric conversion elements PD1 and PD2, and reduce noise by increasing the area of the gate electrode of each of the amplification transistors 105 and 118. It is also possible to reduce kT/C noise inversely proportional to the capacitance value of each of the holding capacitors 108 to 110 by increasing the size of each of the holding capacitors 108 to 110 at the time of the hold operation of each of the SH transistors 111 to 113.

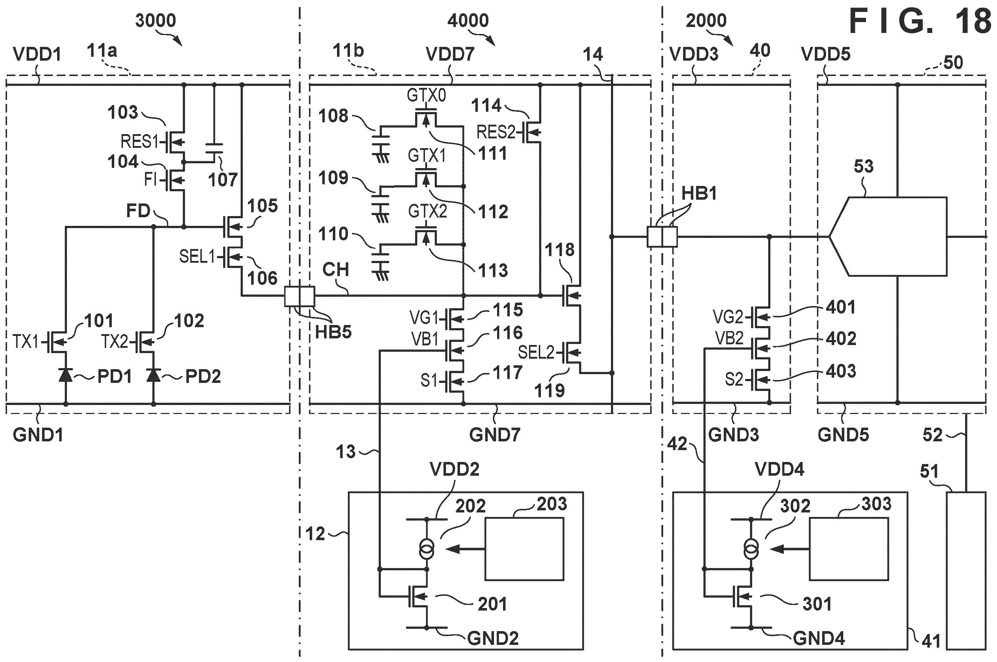

Fig. 18 is a view showing a modification of the configuration shown in Fig. 16. The configuration shown in Fig. 18 is different from that shown in Fig. 16 in terms of the configurations of the pixels 11a and 11b and the arrangement of the bias generator 12.

In the pixel 11a on the semiconductor substrate 3000, the photoelectric conversion elements PD1 and PD2, the transfer transistors 101 and 102, the reset transistor 103, the capacitance selection transistor 104, the amplification transistor 105, the selection transistor 106, and the capacitive element 107 are arranged. In the pixel 11b on the semiconductor substrate 4000, the cascade transistor 115, the current source transistor 116, and the switch 117 are arranged. In addition, in the pixel 11b, the holding capacitors 108 to 110, the SH transistors 111 to 113, the reset transistor 114, the amplification transistor 118, and the selection transistor 119 are arranged. It can be said that the amplifier that amplifies the signals from the photoelectric conversion elements PD1 and PD2 includes the amplification transistor 105 arranged on the semiconductor substrate 3000 and has the gate electrode connected to the node FD as the output node of each of the photoelectric conversion elements PD1 and PD2 and the current source transistor 116 as a current source arranged on the semiconductor substrate 4000 and forming the SF circuit together with the amplification transistor 105. In the configuration shown in Fig. 18, the bias generator 12 is arranged on the semiconductor substrate 4000.

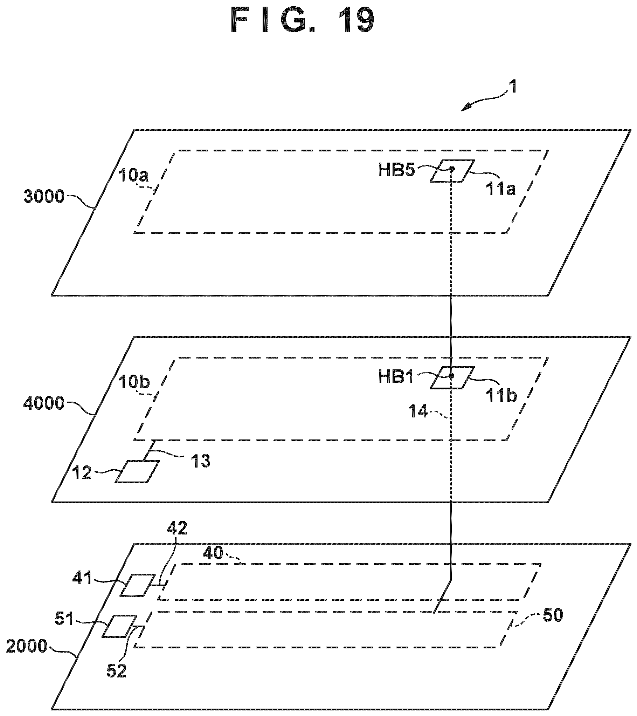

Fig. 19 is a view obtained when stereoscopically viewing the configuration shown in Fig. 18. Similar to the configuration described with reference to Fig. 6, in the configuration shown in Figs. 18 and 19, a process specialized in improving the performance of each of the photoelectric conversion elements PD1 and PD2 can be applied in manufacturing the semiconductor substrate 3000. Furthermore, when the cascade transistor 115, the current source transistor 116, and the switch 117 are arranged in the pixel 11b on the semiconductor substrate 4000, the degree of freedom of size adjustment of the photoelectric conversion elements PD1 and PD2 and the amplification transistor 105 is improved. The current source transistor 116 and the bias generator 12 are arranged on the same semiconductor substrate 4000. This can improve the accuracy of the current value generated by the current source transistor 116.

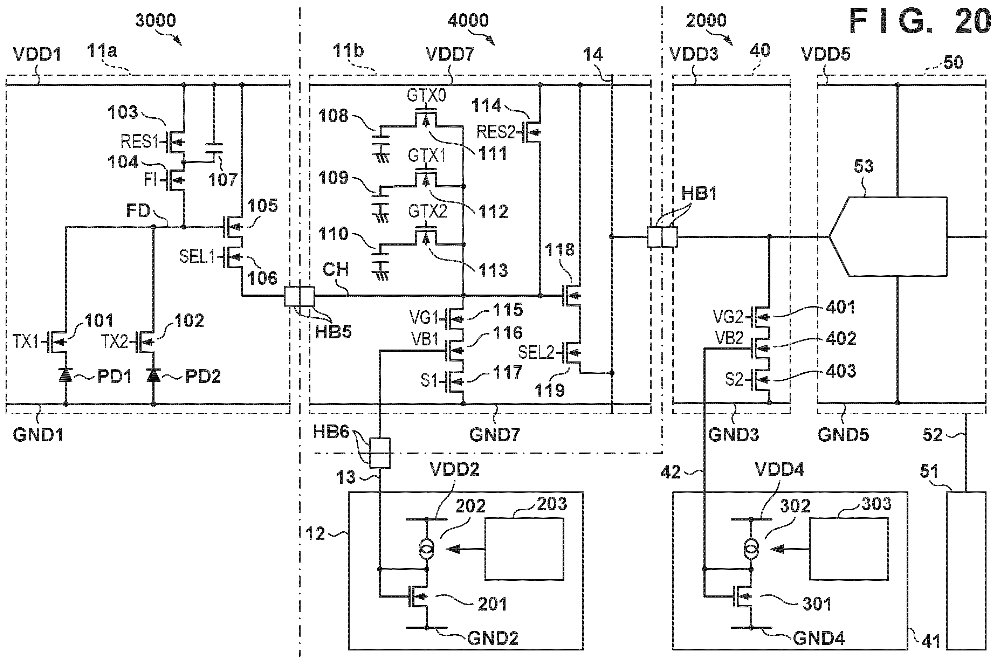

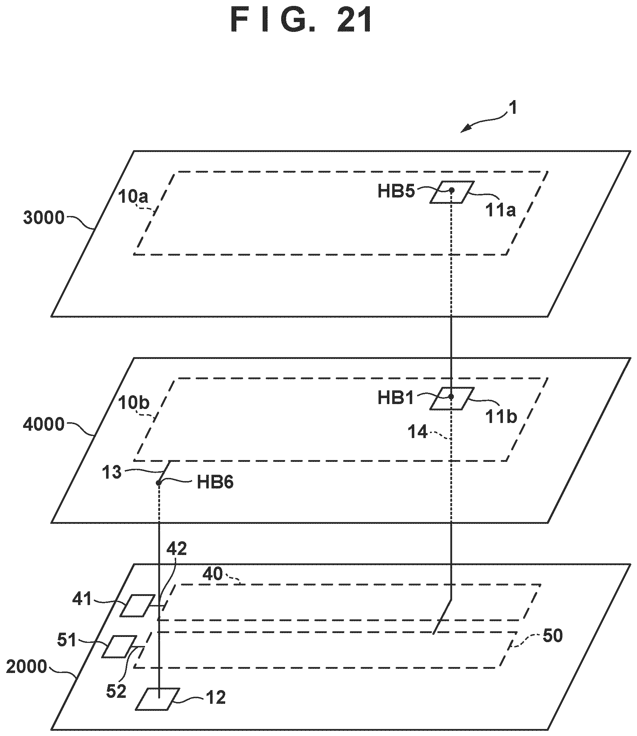

The configuration shown in Fig. 20 is an example of a configuration in which the bias generator 12 is arranged on the semiconductor substrate 2000, as compared to the configuration shown in Fig. 18. The bias line 13 that connects the bias generator 12 and the gate electrode of the current source transistor 116 is electrically connected between the semiconductor substrates 4000 and 2000 via connecting portions HB6. Fig. 21 is a view obtained when stereoscopically viewing the configuration shown in Fig. 20. Similar to the configuration described with reference to Fig. 6, in the configuration shown in Figs. 20 and 21, in a case where the chip size of the photoelectric conversion device 1 is decided based on the size of the pixel 11 (pixels 11a and 11b) and the number of arranged pixels 11, the bias generator 12 is arranged on the semiconductor substrate 2000. This can suppress an increase in chip size of the photoelectric conversion device 1.

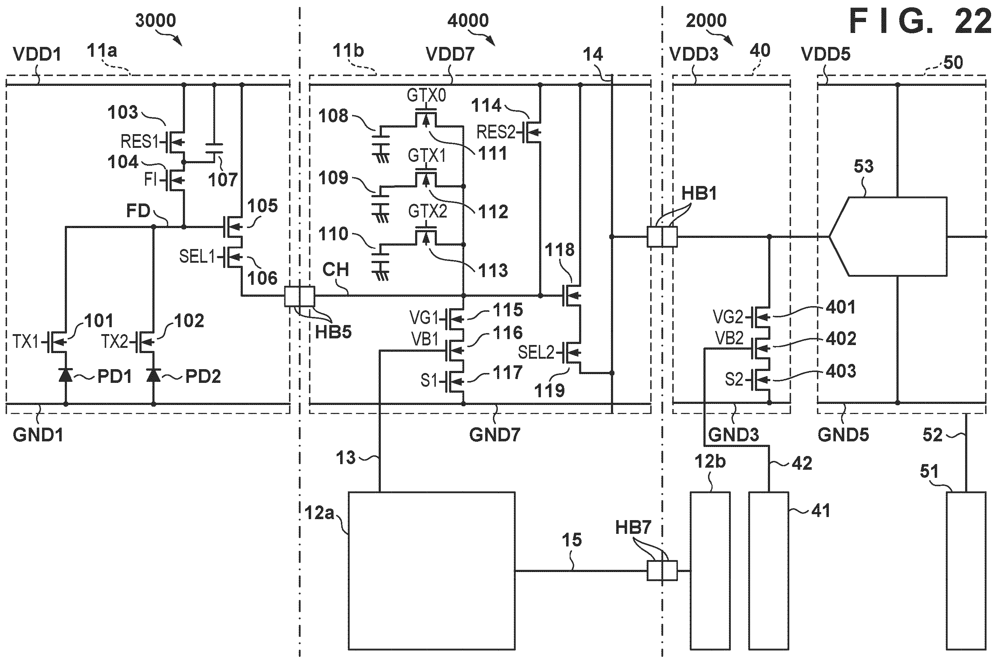

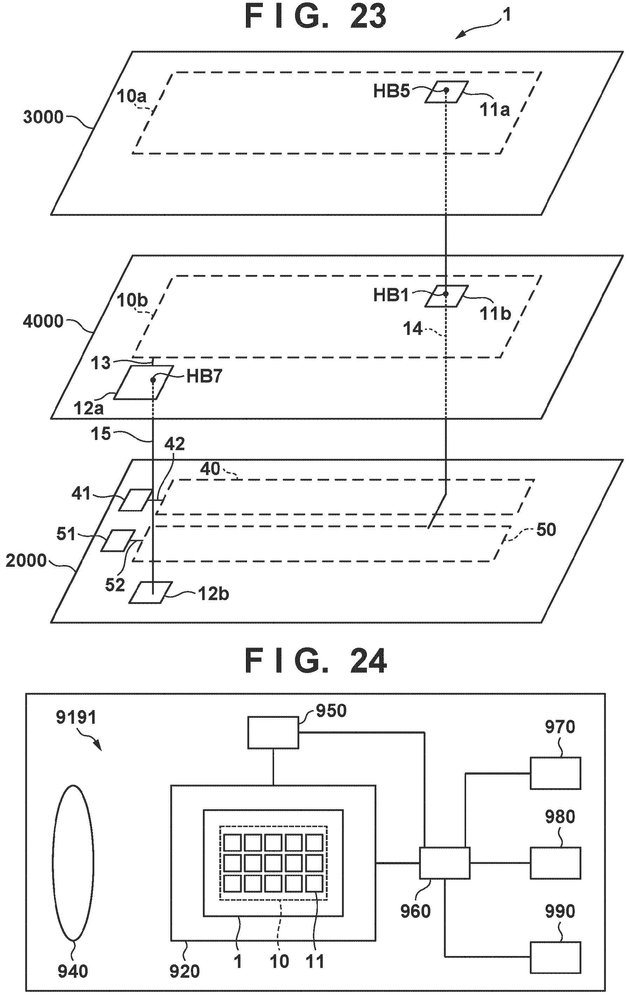

The configuration shown in Fig. 22 is an example of a configuration in which the bias generator 12 includes an element arranged on the semiconductor substrate 4000 and an element arranged on the semiconductor substrate 2000, as compared to the configuration shown in Fig. 20. The bias generator 12a of the bias generator 12 is arranged on the semiconductor substrate 4000, and the bias generator 12b of the bias generator 12 is arranged on the semiconductor substrate 2000. For example, the current generation transistor 201 and the current source 202 may be arranged in the bias generator 12a, and the bias adjuster 203 may be arranged in the bias generator 12b. The bias generators 12a and 12b are electrically connected by the bias adjustment control line 15 via connecting portions HB7. Fig. 23 is a view obtained when stereoscopically viewing the configuration shown in Fig. 22.

In the configuration shown in Figs. 22 and 23 as well, it is possible to obtain the same effects as those described above with reference to Fig. 8. That is, in the configuration shown in Figs. 22 and 23 as well, it is possible to keep the pairing property of the current mirror configuration of the current source transistor 116 and the current generation transistor 201. It is possible to suppress the number of elements arranged on the semiconductor substrate 4000, as compared to the configuration shown in Figs. 18 and 19. On the other hand, the bias adjuster 203 is arranged on the semiconductor substrate 2000. Thus, the bias adjuster 203 can be formed using a logic circuit and elements that operate at a plurality of power supply voltages together with the bias generator 41 and the like.

In the embodiment shown in Figs. 16 to 23 as well, the pixel portion 10 (pixel 11) and the amplifier 40 may share the bias generator, as described with reference to Figs. 10 to 15. In this case, a semiconductor substrate on which the bias generator is arranged and the position on the semiconductor substrate can be decided appropriately, as described above. The bias generator that can be shared by the pixel portion 10 (pixel 11) and the amplifier 40 may be distributed and arranged on two or more semiconductor substrates, similar to the configuration shown in Fig. 13.

As described above, the pixel 11 may be distributed and arranged on the plurality of semiconductor substrates 3000 and 4000 and the semiconductor substrates are stacked. Thus, it is possible to improve the image capturing performance of the photoelectric conversion device 1, for example, it is possible to increase the maximum accumulated charge amounts of the photoelectric conversion elements PD1 and PD2 and reduce noise of the device to be formed while obtaining the same effects as those in a case where the pixel 11 is arranged on one semiconductor substrate 1000.

It will be understood that the above-described embodiment can be combined appropriately, and some components may be omitted in a case where the embodiments are combined. As described above, the drive controller 30, the memory 60, the readout scanner 70, the digital signal processor 80, and the output unit 90 of the photoelectric conversion device 1 may be arranged on the semiconductor substrate 2000 or a semiconductor substrate different from the semiconductor substrate 2000. That is, the drive controller 30, the memory 60, the readout scanner 70, the digital signal processor 80, and the output unit 90 may be arranged on a semiconductor substrate different from the above-described semiconductor substrates 1000 to 4000. As a result, three or four or more semiconductor substrates may be stacked to form the photoelectric conversion device 1. The above-described embodiment has explained the example in which the processing circuit (the amplifier 40 and the A/D converter 50) is arranged on one semiconductor substrate 2000, but the processing circuit may be distributed and arranged on a plurality of stacked semiconductor substrates. For example, the amplifier 40 and the A/D converter 50 may be arranged on different semiconductor substrates.

An application example of the photoelectric conversion device 1 according to the embodiment will be explained with reference to Fig. 24. Fig. 24 is a schematic view of an apparatus 9191 including the photoelectric conversion device 1. As shown in Fig. 24, the photoelectric conversion device 1 is housed in a package 920. The package 920 can include a base to which the photoelectric conversion device 1 is fixed, and a lid such as glass facing the photoelectric conversion device 1. The package 920 can further include joint members such as bonding wires and bumps that connect terminals provided on the base and pads provided on the photoelectric conversion device 1.

The apparatus 9191 can include at least one of an optical device 940, a control device 950, a processing device 960, a display device 970, a storage device 980, and a mechanical device 990. The optical device 940 is implemented by, for example, a lens, a shutter, and a mirror. The control device 950 controls the photoelectric conversion device 1. The control device 950 is, for example, a semiconductor device such as an ASIC.

The processing device 960 processes a signal output from the photoelectric conversion device 1. The processing device 960 is a semiconductor device such as a CPU or an ASIC for forming an analog front end (AFE) or a digital front end (DFE). The display device 970 is an EL display device or a liquid crystal display device that displays information (image) obtained by the photoelectric conversion device 1. The storage device 980 is a magnetic device or a semiconductor device that stores the information (image) obtained by the photoelectric conversion device 1. The storage device 980 is a volatile memory such as an SRAM or a DRAM, or a nonvolatile memory such as a flash memory or a hard disk drive.

The mechanical device 990 includes a moving or propulsion unit such as a motor or an engine. In the apparatus 9191, the signal output from the photoelectric conversion device 1 is displayed on the display device 970 or transmitted to an external device by a communication device (not shown) included in the apparatus 9191. Hence, the apparatus 9191 may further include the storage device 980 and the processing device 960 in addition to the memory circuits and arithmetic circuits included in the photoelectric conversion device 1. The mechanical device 990 may be controlled based on the signal output from the photoelectric conversion device 1.

In addition, the apparatus 9191 is suitable for an electronic apparatus such as an information terminal (for example, a smartphone or a wearable terminal) which has an image capturing function or a camera (for example, an interchangeable lens camera, a compact camera, a video camera, or a monitoring camera). The mechanical device 990 in the camera can drive the components of the optical device 940 in order to perform zooming, an in-focus operation, and a shutter operation. Alternatively, the mechanical device 990 in the camera can move the photoelectric conversion device 1 in order to perform an anti-vibration operation.

Furthermore, the apparatus 9191 can also be applied to an onboard camera mounted in a transportation apparatus such as a vehicle, a ship, an airplane, or an industrial robot. The mechanical device 990 in the transportation apparatus can be used as a moving device. The apparatus 9191 as the transportation apparatus is suitable for a device that transports the photoelectric conversion device 1 or a device that uses an image capturing function to assist and/or automate driving (steering). The processing device 960 for assisting and/or automating driving (steering) can perform, based on the information obtained by the photoelectric conversion device 1, processing for operating the mechanical device 990 as a moving device. The apparatus 9191 incorporating the photoelectric conversion device 1 can be widely applied to an apparatus using object recognition such as an intelligent transport system (ITS), in addition to the transportation apparatus. Alternatively, the apparatus 9191 may be a medical apparatus such as an endoscope, a measurement apparatus such as a distance measurement sensor, an analysis device such as an electron microscope, or an office apparatus such as a copy machine.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. A photoelectric conversion device (1) comprising a plurality of pixels (11) and a processing circuit configured to process signals read out from the plurality of pixels (11), and in which a plurality of semiconductor substrates (1000, 2000, 3000, 4000) are stacked, **characterized in that**
each of the plurality of pixels (11) includes a photoelectric conversion element (PD1, PD2), an amplifier configured to amplify a signal from the photoelectric conversion element(PD1, PD2), and a holding capacitor (108, 109, 110) configured to hold an output from the amplifier,
the photoelectric conversion device (1) further comprises a bias generator (12) configured to supply, to the amplifier, a bias potential for operating the amplifier,
the plurality of semiconductor substrates (1000, 2000, 3000, 4000) include a first semiconductor substrate (3000) on which the photoelectric conversion element (PD1, PD2) is arranged, a second semiconductor substrate (4000) on which the holding capacitor (108, 109, 110) is arranged, and a third semiconductor substrate (2000) on which the processing circuit is arranged, the second semiconductor substrate (4000) being arranged between the first semiconductor substrate (3000) and the third semiconductor substrate(2000),
the amplifier includes an element arranged on the first semiconductor substrate (3000) and an element arranged on the second semiconductor substrate (4000), and
the bias generator (12) is arranged on the third semiconductor substrate (2000).

2. A photoelectric conversion device (1) comprising a plurality of pixels (11) and a processing circuit configured to process signals read out from the plurality of pixels (11), and in which a plurality of semiconductor substrates (1000, 2000, 3000, 4000) are stacked, **characterized in that**
each of the plurality of pixels (11) includes a photoelectric conversion element (PD1, PD2), an amplifier configured to amplify a signal from the photoelectric conversion element (PD1, PD2), and a holding capacitor (108, 109, 110) configured to hold an output from the amplifier,
the photoelectric conversion device (1) further comprises a bias generator (12) configured to supply, to the amplifier, a bias potential for operating the amplifier,
the plurality of semiconductor substrates (1000, 2000, 3000, 4000) include a first semiconductor substrate (3000) on which the photoelectric conversion element (PD1, PD2) is arranged, a second semiconductor substrate (4000) on which the holding capacitor (108, 109, 110) is arranged, and a third semiconductor substrate (2000) on which the processing circuit is arranged, the second semiconductor substrate (4000) being arranged between the first semiconductor substrate (3000) and the third semiconductor substrate (2000),
the amplifier includes an element arranged on the first semiconductor substrate (3000) and an element arranged on the second semiconductor substrate (4000), and
the bias generator (12) is arranged on the second semiconductor substrate (4000).

3. A photoelectric conversion device (1) comprising a plurality of pixels (11) and a processing circuit configured to process signals read out from the plurality of pixels (11), and in which a plurality of semiconductor substrates (1000, 2000, 3000, 4000) are stacked, **characterized in that**
each of the plurality of pixels (11) includes a photoelectric conversion element (PD1, PD2), an amplifier configured to amplify a signal from the photoelectric conversion element (PD1, PD2), and a holding capacitor (108, 109, 110) configured to hold an output from the amplifier,
the photoelectric conversion device (1) further comprises a bias generator (12) configured to supply, to the amplifier, a bias potential for operating the amplifier,
the plurality of semiconductor substrates (1000, 2000, 3000, 4000) include a first semiconductor substrate (3000) on which the photoelectric conversion element (PD1, PD2) is arranged, a second semiconductor substrate (4000) on which the holding capacitor (108, 109, 110) is arranged, and a third semiconductor substrate (2000) on which the processing circuit is arranged, the second semiconductor substrate (4000) being arranged between the first semiconductor substrate (3000) and the third semiconductor substrate(2000),
the amplifier includes an element arranged on the first semiconductor substrate (3000) and an element arranged on the second semiconductor substrate (4000), and
the bias generator (12) includes an element arranged on the second semiconductor substrate (4000) and an element arranged on the third semiconductor substrate(2000).

4. The photoelectric conversion device according to any one of claims 1 to 3, **characterized in that** the amplifier includes a first transistor arranged on the first semiconductor substrate and including a gate electrode connected to an output node of the photoelectric conversion element and a second transistor as a current source arranged on the second semiconductor substrate and forming a source follower circuit together with the first transistor.

5. The photoelectric conversion device according to claim 4, **characterized in that** the bias generator supplies the bias potential to a gate electrode of the second transistor.

6. The photoelectric conversion device according to claim 3, **characterized in that**
the amplifier includes a first transistor arranged on the first semiconductor substrate and including a gate electrode connected to an output node of the photoelectric conversion element and a second transistor as a current source arranged on the second semiconductor substrate and forming a source follower circuit together with the first transistor,
the bias generator includes a third transistor forming a current mirror with the second transistor in order to supply the bias potential to a gate electrode of the second transistor, and
the third transistor is arranged on the second semiconductor substrate.

7. The photoelectric conversion device according to any one of claims 1 to 6, **characterized in that** the amplifier and the bias generator are supplied with power from a common power supply line.

8. The photoelectric conversion device according to any one of claims 1 to 7, **characterized in that** the processing circuit includes an A/D conversion circuit.

9. The photoelectric conversion device according to claim 8, **characterized in that** the amplifier and the A/D conversion circuit are supplied with power from different power supply lines.

10. The photoelectric conversion device according to any one of claims 1 to 9, **characterized in that**
the amplifier is set as a first amplifier and the bias generator is set as a first bias generator,
the processing circuit includes a second amplifier configured to amplify a signal read out from the holding capacitor, and
the photoelectric conversion device further comprises a second bias generator configured to supply, to the second amplifier, a bias potential for operating the second amplifier.

11. The photoelectric conversion device according to claim 10, **characterized in that** the second bias generator is arranged on the third semiconductor substrate.

12. The photoelectric conversion device according to any one of claims 1 to 9, **characterized in that**
the amplifier is set as a first amplifier,
the processing circuit includes a second amplifier configured to amplify a signal read out from the holding capacitor, and
the bias generator supplies, to the second amplifier, a bias potential for operating the second amplifier.

13. A photoelectric conversion device (1) comprising a plurality of pixels (11) and a processing circuit configured to process signals read out from the plurality of pixels (11), and in which a plurality of semiconductor substrates (1000, 2000, 3000, 4000) are stacked, **characterized in that**
each of the plurality of pixels (11) includes a photoelectric conversion element (PD1, PD2), an amplifier configured to amplify a signal from the photoelectric conversion element (PD1, PD2), and a holding capacitor (108, 109, 110) configured to hold an output from the amplifier,
the photoelectric conversion device (1) further comprises a bias generator (12) configured to supply, to the amplifier, a bias potential for operating the amplifier, and
the plurality of semiconductor substrates (1000, 2000, 3000, 4000) include a first semiconductor substrate (3000) on which the photoelectric conversion element (PD1, PD2), the amplifier, and the bias generator (12) are arranged, a second semiconductor substrate (4000) on which the holding capacitor (108, 109, 110) is arranged, and a third semiconductor substrate (2000) on which the processing circuit is arranged, the second semiconductor substrate (4000) being arranged between the first semiconductor substrate (3000) and the third semiconductor substrate (2000).

14. A photoelectric conversion device (1) comprising a plurality of pixels (11) and a processing circuit configured to process signals read out from the plurality of pixels (11), and in which a plurality of semiconductor substrates (1000, 2000, 3000, 4000) are stacked, **characterized in that**
each of the plurality of pixels (11) includes a photoelectric conversion element (PD1, PD2), an amplifier configured to amplify a signal from the photoelectric conversion element (PD1, PD2), and a holding capacitor (108, 109, 110) configured to hold an output from the amplifier,
the photoelectric conversion device (1) further comprises a bias generator (12) configured to supply, to the amplifier, a bias potential for operating the amplifier,
the plurality of pixels (11) are arranged on a first semiconductor substrate (1000) among the plurality of semiconductor substrates (1000, 2000, 3000, 4000),
the processing circuit is arranged on a semiconductor substrate different from the first semiconductor substrate (1000) among the plurality of semiconductor substrates (1000, 2000, 3000, 4000), and
at least part of the bias generator (12) is arranged on the first semiconductor substrate (1000).

15. A photoelectric conversion device (1) comprising a plurality of pixels (11) and a processing circuit configured to process signals read out from the plurality of pixels (11), and in which a plurality of semiconductor substrates (1000, 2000, 3000, 4000) are stacked, **characterized in that**
each of the plurality of pixels (11) includes a photoelectric conversion element (PD1, PD2), an amplifier configured to amplify a signal from the photoelectric conversion element (PD1, PD2), and a holding capacitor (108, 109, 110) configured to hold an output from the amplifier,
the photoelectric conversion device (1) further comprises a bias generator (12) configured to supply, to the amplifier, a bias potential for operating the amplifier,
the plurality of pixels (11) are arranged on a first semiconductor substrate (1000) among the plurality of semiconductor substrates (1000, 2000, 3000, 4000), and
the processing circuit and the bias generator (12) are arranged on a semiconductor substrate different from the first semiconductor substrate (1000) among the plurality of semiconductor substrates (1000, 2000, 3000, 4000).

16. An apparatus **characterized by** comprising:
the photoelectric conversion device according to any one of claims 1 to 15; and
a processing device configured to process a signal output from the photoelectric conversion device.
